# EUROPÄISCHE PATENTSCHRIFT

(11) **EP 0 833 422 B1**
(45) Veröffentlichungstag und Bekanntmachung des Hinweises auf die Patenterteilung: **08.05.2002**
(21) Anmeldenummer: 97810605.2
(22) Anmeldetag: 27.08.1997
(51) Int. Cl.: H02H 7/122

(54) **Stromrichterschaltung**
Power converter
Ensemble de convertisseur

(30) Priorität: 25.09.1996 DE 19639279
(43) Veröffentlichungstag der Anmeldung: 01.04.1998
(73) Patentinhaber: DaimlerChrysler Rail Systems GmbH, 13627 Berlin (DE)
(72) Erfinder: Hilpert, Gerald, 79787 Lauchringen (DE)
(74) Vertreter: Cohausz & Florack Patentanwälte

(56) Entgegenhaltungen:
- EP-A- 0 166 968
- EP-A- 0 642 199

## Beschreibung

### TECHNISCHES GEBIET

Bei der Erfindung wird ausgegangen von einer Stromrichterschaltung nach dem Oberbegriff des Patentanspruchs 1.

### STAND DER TECHNIK

Mit dem Oberbegriff des Patentanspruchs 1 nimmt die Erfindung auf einen Stand der Technik Bezug, wie er aus der DE 3 420 535 A1 bekannt ist. Dort ist ein als Chopper betriebenes Halbleiter-Modul mit mehreren zueinander parallelgeschalteten Feldeffekttransistoren, insbesondere MOS-FET's, für eine Schaltfrequenz von 20 kHz mit Schaltzeiten von etwa 100 ns für Ströme von 120 A beschrieben, bei dem in unmittelbarer Nachbarschaft zu jedem Feldeffekttransistor eine Diode über einen Stützkondensator elektrisch parallelgeschaltet ist. Durch die enge Parallelführung resultiert eine Gesamtinduktivität von nur ca. 20 nH. Beim Abschalten von 100 A in 100 ns ergibt sich dabei eine Überspannung von nur 20 V.

Nachteilig dabei ist, daß sich bei einem Defekt eines Feldeffekttransistors in einem Kurzschlußfall sehr hohe Kondensatorentladeströme einstellen, die über einen Lichtbogen zu einer Zerstörung des Bauelements und zu einer Explosion des Moduls führen können.

Aus der DE 4 330 381 A1 ist eine Schutzschaltung für einen Stromkreis mit einer Kondensatorschaltung bekannt, bei der bei einem Umrichter mit einem Gleichspannungszwischenkreis im Falle des Kurzschlusses eines Zwischenkreiskondensators ein reversibler Kurzschlußstrombegrenzer unzulässig hohe Kurzschlußströme im Gleichspannungszwischenkreis und in den Phasenbausteinen des betroffenen Stromrichters verhindert. Dieser Kurzschlußstrombegrenzer weist einen Kaltleiter auf, der niederinduktiv und gekühlt zu mindestens einem Kondensator oder zu einer Kondensatorbank des Gleichspannungszwischenkreises in Reihe geschaltet ist. Der Kaltleiter kann im Gleichspannungszwischenkreis oder im Stromrichter angeordnet sein. Parallel zu dem Kaltleiter kann ein Varistor und/oder ein ohmscher Widerstand und/oder eine Diode in Sperrichtung eines Kurzschlußpfades geschaltet sein, wobei Kaltleiter und Varistor oder Kaltleiter und ohmscher Widerstand zu einem Bauelement vereinigt sein können.

Aus der US-A-4,583,146 ist es bekannt, parallel zu einem mechanischen Unterbrecherkontakt einen Kaltleiter und einen Varistor zu schalten.

Aus der DE-OS 2 831 495 ist ein Überstromschutz für einen Zwischenkreisumrichter oder selbstgeführten Wechselrichter bekannt, bei dem in Reihe zum Zwischenkreiskondensator ein im Normalbetrieb leitender Transistor geschaltet ist, der im Störfall ausgeschaltet wird. Antiparallel zu diesem Transistor ist eine Diode geschaltet.

Aus der DE 38 37 458 A1 ist das Herstellen einer Schmelzsicherung durch Bonden bekannt.

### DARSTELLUNG DER ERFINDUNG

Die Erfindung, wie sie im Patentanspruch 1 definiert ist, löst die Aufgabe, eine Stromrichterschaltung der eingangs genannten Art derart weiterzuentwickeln, daß infolge von Störungen auftretende Überströme sofort auf intakte steuerbare Halbleiterbauelemente verteilt werden.

Ein Vorteil der Erfindung besteht darin, daß das Modul mit den abschaltbaren Halbleiterbauelementen nicht explodiert. Die in einem Fehlerfall freiwerdende Energie verteilt sich im ganzen Modul, so daß die fehlerfreien Halbleiterbauelemente nicht schmelzen.

### KURZE BESCHREIBUNG DER ZEICHNUNGEN

Die Erfindung wird nachstehend anhand eines Ausführungsbeispiels erläutert. Es zeigen:
- Fig. 1: eine 2Punkt-Stromrichterschaltung mit einem Antriebsstromrichter, der über einen Gleichspannungszwischenkreis mit einem Netzstromrichter verbunden ist,
- Fig. 2: einen prinzipiellen Aufbau eines Bipolartransistors mit isoliertem Gate mit Freilaufdiode des Antriebsstromrichters gemäß Fig. 1 und
- Fig. 3: ein Signaldiagramm zur Erläuterung der Wirkung der erfindungsgemäßen Maßnahme.

### WEGE ZUR AUSFÜHRUNG DER ERFINDUNG

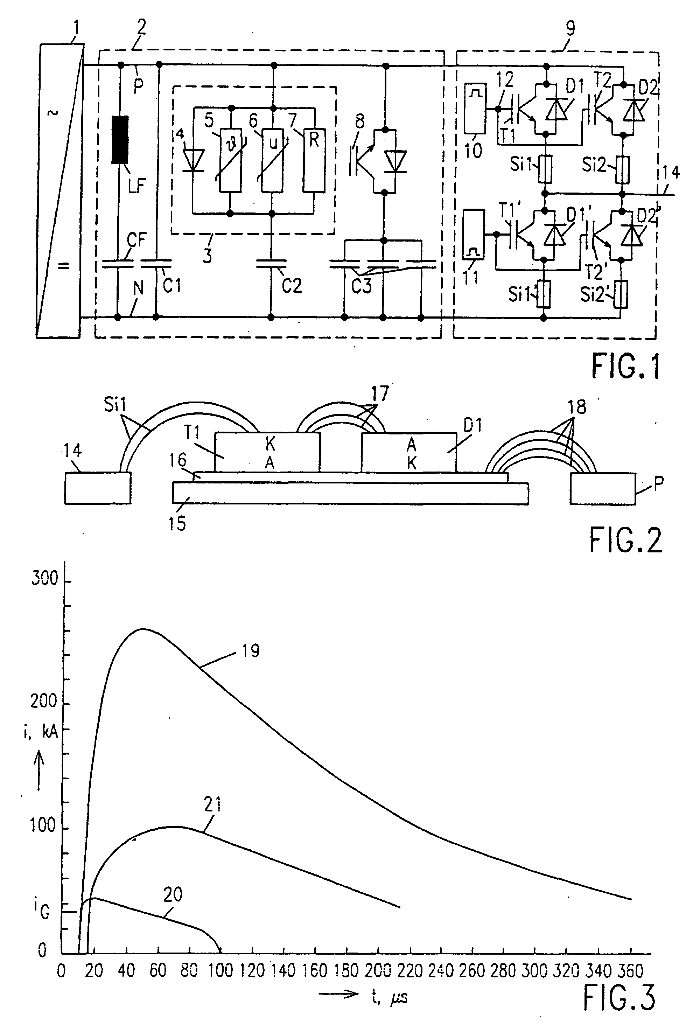

Fig. 1 zeigt einen Netzstromrichter oder 1. Stromrichter (1), der gleichspannungsseitig über einen Gleichspannungszwischenkreis (2) mit einem Antriebsstromrichter bzw. 2. Stromrichter (9) elektrisch verbunden ist.

Der Gleichspannungszwischenkreis (2) weist zwischen einem positiven Pol bzw. einer positiven Stromschiene (P) und einem negativen Pol bzw. einer negativen Stromschiene (N) eine Gleichspannung von z. B. 3,4 kV und ein elektrisches Filter zur Dämpfung von Zwischenkreisoberschwingungen aus einer Reihenschaltung einer Filterdrossel (LF) und eines Filterkondensators (CF) auf; ferner Zwischenkreiskondensatoren bzw. Kondensatoren (C1, C2), wobei der Kondensator (C2) mit einem reversiblen Kurzschlußstrombegrenzer (3) in Reihe geschaltet ist. Der reversible Kurzschlußstrombegrenzer (3) weist eine Parallelschaltung einer in Sperrichtung eines Kurzschlußpfades gepolten Diode (4), eines Kaltleiters (5), eines Überspannungsableiters bzw. Varistors (6) und eines ohmschen Widerstandes (7) auf. Der Kaltleiter (5) ist im Kurzschlußstrombegrenzer (3) stets vorhanden; Varistor (6), ohmscher Widerstand (7) und Diode (4) können einzeln oder in Kombination zu dem Kaltleiter (5) parallelgeschaltet sein.

Ein Kaltleiter (5) zeigt sog. PTC-Verhalten (PTC = positiver Temperaturkoeffizient). Vorzugsweise sind Kaltleiter (5) und Varistor (6) zu einem Widerstandskörper vereinigt. Besonders geeignet ist auch ein Widerstandskörper, der einen Kaltleiter (5) mit einem ohmschen Widerstand (7) in einem Bauelement vereinigt.

Eine Zwischenkreis-Kondensatorbank (C3) ist mit einem Bipolartransistor mit isoliertem Gate (IGBT) (8) in Reihe geschaltet, der normalerweise eingeschaltet ist und in einem Fehlerfall abgeschaltet wird. Antiparallel zu dem Bipolartransistor mit isoliertem Gate (8) ist eine Diode zum Aufladen der Zwischenkreis-Kondensatorbank (C3) geschaltet. Es versteht sich, daß anstelle einer Zwischenkreis-Kondensatorbank (C3) auch mehrere einzelne Kondensatoren je mit einem derartigen Bipolartransistor mit isoliertem Gate (8) in Reihe geschaltet sein können.

Die beiden Stromrichter (1, 9) sind als 2Punkt-Stromrichter ausgeführt, wobei für den Stromrichter (9) in Fig. 1 nur 4 Hauptventilzweige mit 4 Bipolartransistoren mit isoliertem Gate (T1, T2; T1', T2') als Hauptventilen für eine Wechselstromphase, die an einer Wechselspannungsklemme (14) abgreifbar ist, gezeigt sind. Für 3phasigen Wechselstrom sind entsprechend 3 · 4 gleichartig aufgebaute Hauptventilzweige erforderlich. Zu jedem Bipolartransistor mit isoliertem Gate (T1, T2; T1', T2') ist eine Freilaufdiode (D1, D2; D1', D2') elektrisch antiparallel geschaltet. In Reihe zu jeder derartigen Parallelschaltung von Bipolartransistor mit isoliertem Gate (T1, T2; T1', T2') und Freilaufdiode (D1, D2; D1', D2') ist jeweils, kathodenseitig bezüglich des Bipolartransistors mit isoliertem Gate, ein Kurzschlußstrombegrenzer bzw. eine Schmelzsicherung (Si1, Si2; Si1', Si2') vorgesehen, die beim Überschreiten einer vorgebbaren Grenzstromstärke (i_{G}) durchschmilzt. Vorzugsweise besteht diese Schmelzsicherung (Si1, Si2; Si1', Si2') aus Bond-Drähten aus Aluminium, deren Durchmesser und Anzahl so bemessen sind, daß sie beim Überschreiten der vorgebbaren Grenzstromstärke (i_{G}) schmelzen und somit einen Strom durch den zugehörigen Bipolartransistor mit isoliertem Gate (T1, T2; T1', T2') oder die Freilaufdiode (D1, D2; D1', D2') unterbrechen. Zwischen der positiven Stromschiene (P) und der Wechselspannungsklemme (14) sind mindestens 2 Bipolartransistoren mit isoliertem Gate (T1, T2) mit dazugehörigen Freilaufdioden (D1, D2) über ihre Schmelzsicherung (Si1, Si2) elektrisch parallelgeschaltet. Ebenso sind zwischen der negativen Stromschiene (N) und der Wechselspannungsklemme (14) mindestens 2 Bipolartransistoren mit isoliertem Gate (T1', T2') mit dazugehörigen Freilaufdioden (D1', D2') über ihre Schmelzsicherung (Si1', Si2') elektrisch parallelgeschaltet. Die Bipolartransistoren mit isoliertem Gate (T1, T2) werden über einen Schaltsignalgenerator (10) gemeinsam gesteuert und die Bipolartransistoren mit isoliertem Gate (T1', T2') über einen Schaltsignalgenerator (11).

Fig. 2 zeigt den prinzipiellen Aufbau für den Bipolartransistor mit isoliertem Gate (T1) mit antiparalleler Freilaufdiode (D1), die beide über ein elektrisch gutleitendes Kontaktierungselement (16), vorzugsweise aus Kupfer, über Bond-Drähte (18), vorzugsweise aus Reinstaluminium, mit der positiven Stromschiene (P) elektrisch verbunden sind. Das Kontaktierungselement (16) ist gutleitend mit einer Grundplatte (15), vorzugsweise aus Aluminiumnitrid, verbunden, welche gleichzeitig als Wärmesenke dient. Der Bipolartransistor mit isoliertem Gate (T1) ist kathodenseitig mit der Anodenseite der Freilaufdiode (D1) über Bond-Drähte (17) und über die Schmelzsicherung (Si1) mit der Wechselspannungsklemme (14) elektrisch verbunden. Anodenseitig ist der Bipolartransistor mit isoliertem Gate (T1) und kathodenseitig die Diode (D1) über das Kontaktierungselement (16) und die Bond-Drähte (18) mit der positiven Stromschiene (P) elektrisch verbunden. Der Steuersignalanschluss (12) ist in Fig. 2 nicht dargestellt.

Wichtig ist, dass der kathodenseitige Stromanschluss des Bipolartransistors mit isoliertem Gate (T1) einen kleineren, vorzugsweise mindestens 10 % kleineren elektrischen Widerstand als dessen anodenseitiger Anschluss aufweist. Dies ist in Fig. 2 dadurch angedeutet, dass die Anzahl der Bond-Drähte (Si1) kleiner ist als die Anzahl der Bond-Drähte (17) und (18). Die Bond-Drähte sind querschnitts- und zahlenmässig so zu bemessen, dass in einem Kurzschlussfall die Bond-Drähte (Si1) sicher schmelzen, während die Bond-Drähte (17) und (18) nicht schmelzen dürfen.

In Fig. 3 ist auf der Ordinate die Stromstärke (i) in kA und auf der Abszisse die Zeit (t) in µs aufgetragen. Eine Kurve (19) zeigt den zeitlichen Verlauf eines Kurzschlussstromes zwischen der positiven Stromschiene (P) und der negativen Stromschiene (N) über fehlerhaft gleichzeitig leitend geschaltete Bipolartransistoren mit isoliertem Gate (T1, T2; T1', T2'), ohne Kondensator (C1) und ohne Schmelzsicherungen (Si1, Si2; Si1', Si2'). Die Zwischenkreiskondensatoren (C2) und (C3) entladen sich über diese Bipolartransistoren mit isoliertem Gate (T1, T2; T1', T2') und bewirken innerhalb von 40 µs einen Stromanstieg auf etwa 260 kA, der zu einer Lichtbogenbildung und Explosion des Moduls mit den Bipolartransistoren mit isoliertem Gate (T1, T2; T1', T2') führt.

Eine Kurve (20) zeigt den zeitlichen Verlauf des Stromes durch einen defekten Bipolartransistor mit isoliertem Gate, z. B. (T1), bei Vorhandensein der Schmelzsicherungen (Si1, Si2; Si1', Si2'). Überschreitet die Stromstärke (i) durch den Bipolartransistor mit isoliertem Gate (T1) oder durch die Diode (D1) die Grenzstromstärke (i_{G}), so schmilzt die Schmelzsicherung (Si1) und möglicherweise auch der Bipolartransistor mit isoliertem Gate (T1). Der Strom durch diese beiden Bauelemente verschwindet innerhalb von etwa 100 µs. Durch das Schmelzen der Schmelzsicherung (Si1) und eventuell des Bipolartransistors mit isoliertem Gates (T1) erhält dessen Steuersignalanschluß (12) das Spannungspotential der positiven Stromschiene (P), so daß der parallelgeschaltete Bipolartransistor mit isoliertem Gate (T2) leitend wird, da dessen Steuersignalanschluß mit dem Steuersignalanschluß (12) des Bipolartransistors mit isoliertem Gate (T1) leitend verbunden ist. Dieser Bipolartransistor mit isoliertem Gate (T2) und etwaige weitere parallelgeschaltete Bipolartransistoren mit isoliertem Gate (nicht dargestellt) übernehmen nun gemeinsam den Kurzschlußstrom gemäß einer Kurve (21) bis zu einem Zeitpunkt, da die Energie der Zwischenkreiskondensatoren (C1 - C3) verbraucht ist (etwa nach 5 ms - 10 ms) oder bis eine übergeordnete Schutzeinrichtung (nicht dargestellt) den Fehler erfaßt hat und die Stromzufuhr unterbricht. Die Stromstärke (i) durch die einzelnen, parallelgeschalteten Bipolartransistoren mit isoliertem Gate (T2) liegt jeweils unterhalb der Grenzstromstärke (i_{G}) von deren Schmelzsicherung (Si2). Nur die Summenstromstärke kann größer sein. Durch diese Maßnahme wird verhindert, daß außer dem defekten Bipolartransistor mit isoliertem Gate (T1) bzw. der defekten Freilaufdiode (D1) noch weitere Bipolartransistoren mit isoliertem Gate schmelzen und damit zerstört werden. Die Anzahl parallelgeschalteter Bipolartransistoren mit isoliertem Gate muß so gewählt werden, daß sie in einem Fehlerfall den Kurzschlußstrom übernehmen können, ohne zerstört zu werden.

Die Beanspruchung der Bipolartransistoren mit isoliertem Gate (T1, T2; T1', T2') in einem Kurzschlußfall ist von der elektrischen Energie E der Zwischenkreis-Kondensatoren (C1 - C3) abhängig gemäß E = 0,5 · (C1 + C2 + C3) · U².
Bei einer Zwischenkreisspannung U von 3,4 kV und C1 + C2 + C3 = 6 mF ist E = 34,7 kJ.
Durch den Kurzschluß wird diese Energie umgesetzt in:
- Stromwärme im Widerstand des Kurzschlußzweiges (erwünscht),
- Verformungsarbeit (nicht erwünscht) sowie
- Lichtbogenwärme und -strahlung (nicht erwünscht).

Ein Lichtbogen entsteht, wenn sich die galvanische Verbindung durch die Verformungsarbeit und/oder die Stromwärme öffnet. Das thermisch bedingte Aufreißen der Bond-Drähte (Si1, Si2; Si1', Si2') wird durch magnetische Stromkräfte beschleunigt.

Nach einem Schmelzen der Bond-Drähte (Si1, Si2; Si1', Si2') liegt noch eine Spannung von den Zwischenkreis-Kondensatoren (C1 - C3) von etwa 3 kV über den Kontaktpunkten der Bond-Drähte. Der Stromabriß nach dem Schmelzen führt zusätzlich zu einer Abschaltüberspannung. Die verbleibenden Reststücke der Bond-Drähte verursachen eine starke Feldüberhöhung.

In Reihe geschaltete Bipolartransistoren mit isoliertem Gate (T1, T1'; T2', T2') dürfen im Normalbetrieb niemals gleichzeitig leitend sein.

Vorteilhaft ist es, wenn im Kurzschlußstrompfad mindestens eines Zwischenkreiskondensators (C2) ein reversibler Kurzschlußstrombegrenzer (3) vorgesehen ist. Dadurch werden etwaige Kurzschlußentladeströme des Kondensators (C2) auf Werte begrenzt, die mindestens unterhalb der Zerstörungsgrenze der passiven Komponenten und der Stromschienen liegen, idealerweise unterhalb der Zerstörungsgrenze der aktiven Bauelemente. Die hierfür erforderlichen Reaktionszeiten der Schutzschaltung liegen im Bereich von 100 µs.

Die Schutzschaltungen gemäß Fig. 1 gewährleisten sowohl bei einem Teilkurzschluß als auch bei einem Vollkurzschluß eines Stromrichters (1, 9) einen guten Schutz.

Durch die Parallelschaltung einer Diode (4) zu einem Kaltleiter (5) kann die thermische Dauerstrombelastung des reversiblen Kurzschlußstrombegrenzers (3) reduziert werden. Bei Betrieb unter Nennbedingungen leitet die Diode (4) während einer Halbperiode der Zwischenkreis-Pulsfrequenz und reduziert so den Effektivstrom. Im Kurzschlußfall sperrt die Diode (4), und die Schutzfunktion des reversiblen Kurzschlußstrombegrenzers (3) ist voll wirksam.

Läßt man einen oder mehrere Zwischenkreiskondensatoren (C1) ohne reversiblen Kurzschlußstrombegrenzer (3), während die übrigen Zwischenkreiskondensatoren (C2) einen aufweisen, so erreicht man einen Schutz gegen Abschaltüberspannungen. Die Kurzschlußstromamplitude des Gesamtstromes im Gleichspannungszwischenkreis erhöht sich jedoch anteilmäßig.

Es versteht sich, daß auch der 1. Stromrichter (1) erfindungsgemäß mit Schmelzsicherungen (Si1, Si2; Si1', Si2') beschaltete Bipolartransistoren mit isoliertem Gate (T1, T2; T1', T2') und mit dazugehörigen Freilaufdioden (D1, D2; D1', D2') aufweisen kann.

Anstelle von Bipolartransistoren mit isoliertem Gate (T1, T2; T1', T2') können auch andere abschaltbare Halbleiterbauelemente, insbesondere Feldeffekttransistoren, eingesetzt sein.

### BEZEICHNUNGSLISTE

- 1: Netzstromrichter, 1. Stromrichter
- 2: Gleichspannungszwischenkreis
- 3: Kurzschlußstrombegrenzer
- 4: Diode
- 5: Kaltleiter
- 6: Varistor, Überspannungsableiter
- 7: ohmscher Widerstand
- 8: Bipolartransistor mit isoliertem Gate
- 9: Antriebsstromrichter, 2. Stromrichter
- 10, 11: Schaltsignalgeneratoren für T1 - T2'
- 12: Gate, Steuersignalanschluß von T1
- 14: Wechselspannungsklemme von 9
- 15: Grundplatte, Kühlungselement
- 16: elektrisches Kontaktierungselement von T1, D
- 17, 18: Kontaktierungselemente, Bond-Drähte
- 19: zeitlicher Verlauf des Kurzschlußstromes ohne erfindungsgemäße Maßnahme
- 20: zeitlicher Verlauf des Kurzschlußstromes durch einen defekten Bipolartransistor mit isoliertem Gate mit erfindungsgemäßer Maßnahme
- 21: zeitlicher Verlauf des Kurzschlußstromes durch parallelgeschaltete Bipolartransistoren mit isoliertem Gate
- C1, C2: Zwischenkreiskondensatoren
- C3: Zwischenkreis-Kondensatorbank
- CF: Filterkondensator
- D1, D2; D1',: D2' Freilaufdioden
- i: Stromstärke
- i_{G}: Grenzstromstärke
- LF: Filterdrossel
- N: negativer Pol, negative Stromschiene
- P: positiver Pol, positive Stromschiene
- Si1, Si2, Si1', Si2': Kurzschlußstrombegrenzer, Schmelzsicherungen, Bond-Drähte
- t: Zeit
- T1 - T2': Bipolartransistoren mit isoliertem Gate, IGBTs

## Patentansprüche

1. Stromrichterschaltung mit:
a) mindestens vier steuerbaren Halbleiterbauelementen (T1, T2, T1', T2'), von denen jeweils zwei anoden- und kathodenseitig parallelgeschaltet sind und die jeweils einen Steuersignalanschluss (12) aufweisen,
b) wobei der kathodenseitige Anschluss jedes der parallelgeschalteten steuerbaren Halbleiterbauelemente (T1, T2, T1', T2') einen Kurzschlussstrombegrenzer (Si1, Si2, Si1', Si2') aufweist, der durch ein Durchschmelzen einen Kurzschlussstrom (i) beim Überschreiten einer vorgebbaren Grenzstromstärke (i_{G}) unterbricht und aus Bonddrähten besteht,
c) der anodenseitige Anschluss jedes der parallelgeschalteten steuerbaren Halbleiterbauelemente (T1, T2, T1', T2') so dimensioniert ist, dass er bei einem Durchschmelzen eines dieser Kurzschlussstrombegrenzer (Si1, Si2, Si1', Si2') nicht durchschmilzt, und
d) der Steuersignalanschluss (12) jedes steuerbaren Halbleiterbauelements (T1, T2, T1', T2') mit einem Steuersignalanschluss (12) eines parallelgeschalteten Halbleiterbauelements (T1, T2, T1', T2') elektrisch verbunden ist,
wobei der elektrische Widerstand des anodenseitigen Anschlusses jedes der parallelgeschalteten steuerbaren Halbleiterbauelemente (T1, T2, T1', T2') mindestens 10% kleiner ist als der elektrische Widerstand von dessen kathodenseitigem Anschluss (Si1, Si2, Si1', Si2').

2. Stromrichterschaltung nach Anspruch 1, wobei
die steuerbaren Halblelterbauelemente (T1, T2, T1', T2') Bipolartransistoren mit isoliertem Gate (8) sind.

3. Stromrichterschaltung nach Anspruch 1 oder 2, wobei
zu jedem steuerbaren Halbleiterbauelement (T1, T2, T1', T2') eine Freilaufdiode (D1, D2, D1', D2') antiparallel geschaltet ist und
der Kurzschlussstrombegrenzer (Si1, Si2, Si1', Si2') an eine elektrische Verbindungsstelle von steuerbarem Halbleiterbauelement (T1, T2, T1', T2') und Freilaufdiode (D1, D2, D1', D2') angeschlossen ist.

## Claims

1. A converter connection with:
a) at least four controllable semiconductor components (T1, T2, T1', T2'), of which two are connected in parallel by the anode and two in parallel by the cathode, and each is furnished with a control signal connection (12),
b) wherein the cathode connection of each of the parallel connected controllable semiconductors (T1, T2, T1', T2') is furnished with a short circuit current limiter (Si1, Si2, Si1', Si2') that is made from bonding wires and that interrupts a short circuit current (i) by fusing when a definable threshold current (iₑ) is exceeded,
c) the connection on the anode of each of the parallel connected controllable semiconductor components (T1, T2, T1', T2') is of such a size that it does not fuse when one of these short circuit current limiters (Si1, Si2, Si1', Si2') fuses, and
d) the control signal connection (12) of each controllable semiconductor component (T1, T2, T1', T2') is electrically connected to a control signal connection of a parallel connected semiconductor component (T1, T2, T1', T2'),
wherein the electrical resistance of the connection on the anode side of each of the parallel connected controllable semiconductor components (T1, T2, T1', T2') is smaller by at least 10 % than the electrical resistance of the connection thereof on the cathode side (Si1, Si2, Si1', Si2').

2. The converter connection according to claim 1,
wherein the controllable semiconductor components (T1, T2, T1', T2') are bipolar transistors with isolated gate (8).

3. The converter connection according to claim 1 or 2,
wherein a recovery diode (D1, D2, D1', D2') is connected in antiparallel to each controllable semiconductor component (T1, T2, T1', T2') and the short circuit current limiter (Si1, Si2, Si1', Si2') is connected to an electrical junction between controllable semiconductor component (T1, T2, T1', T2') and recovery diode (D1, D2, D1', D2').

## Revendications

1. Montage convertisseur équipé :
a) d'au moins quatre composants semi-conducteurs (T1, T2, T1', T2') contrôlables dont respectivement deux sont branchés en parallèle côté anode et deux côté cathode et qui présentent chacun un branchement de signal de commande (12),
b) le branchement côté cathode de chacun des composants semi-conducteurs (T1, T2, T1', T2') contrôlables et branchés en parallèle présentant un limiteur de courant de court-circuit (Si1, Si2, Si1', Si2'), qui interrompt par fusion un courant de court-circuit (i) lors du dépassement d'une intensité de courant limite (iₑ) prédéfinissable et qui est à base de fils de bonding,
c) le branchement côté anode de chacun des composants semi-conducteurs (T1, T2, T1', T2'), contrôlables et branchés en parallèle étant dimensionné de telle façon qu'il ne fond pas à l'occasion d'une fonte de l'un de ces limiteurs de courant de court-circuit (Si1, Si2, Si1', Si2') et
d) le branchement de signal de commande (12) de chaque composant semi-conducteur (T1, T2, T1', T2') contrôlable et étant relié électriquement à un branchement de signal de commande (12) d'un composant semi-conducteur (T1, T2, T1', T2') branché en parallèle,
la résistance électrique du branchement côté anode de chacun des composants semi-conducteurs (T1, T2, T1', T2') contrôlables et branchés en parallèle étant inférieure d'au moins 10 % à la résistance électrique de son branchement côté cathode (Si1, Si2, Si1', Si2').

2. Montage convertisseur selon la revendication 1, les composants semi-conducteurs (T1, T2, T1', T2') contrôlables étant des transistors bipolaires avec une porte (8) isolée.

3. Montage convertisseur selon la revendication 1 ou 2, une diode de roue libre (D1, D2, D1', D2') étant branchée de façon anti-parallèle par rapport à chaque composant semi-conducteur (T1, T2, T1', T2') contrôlable et le limiteur de courant de court-circuit (Si1, Si2, Si1', Si2') étant raccordé à un point de jonction électrique entre le composant semi-conducteur (T1, T2, T1', T2') contrôlable et la diode de roue libre (D1, D2, D1', D2').
